# EUROPEAN PATENT SPECIFICATION

(11) **EP 0 310 222 B1**
(45) Date of publication and mention of the grant of the patent: **23.06.1993**
(21) Application number: 88306787.8
(22) Date of filing: 22.07.1988
(51) Int. Cl.: H03J 5/24, H03D 9/06

(54) **Multiple-band mixer circuit**
Mischerschaltung für verschiedene Bereiche
Circuit mélangeur pour plusieurs bandes de fréquences

(30) Priority: 01.10.1987 JP 150999/87
(43) Date of publication of application: 05.04.1989
(73) Proprietor: SHARP KABUSHIKI KAISHA, Osaka 545 (JP)
(72) Inventor: Noboru, Mitsuhiro, Minamikawachi-gun Osaka-fu (JP)
(74) Representative: Brown, Kenneth Richard

(56) References cited:
- US-A- 4 509 198
- PATENT ABSTRACTS OF JAPAN, vol. 10, no. 283 (E-440)[2339], 26th September 1989; & JP-A-61 101 133 (TOSHIBA CORP.) 20-05-1986

## Description

This invention relates to a multiple-band mixer circuit for use in an LNB (Low Noise Blockdown Converter) for the outdoor unit of a satellite broadcast receiving station, which circuit is capable of receiving multiple, say, two bands of broadcast wave.

The conventional two-band mixer circuit contains two independent mixer circuit blocks each to receive one of two bands, i.e., the first and second bands. To select either of the two bands, a selection circuit is connected to the two mixer circuit blocks, allowing either of the mixer circuit blocks to operate. Two monitor circuits are connected separately to the two circuit mixer blocks, respectively, to check for the operation of the mixer circuit blocks. As a result, the two-band mixer circuit is large and does not meet the increasing demand for smaller components for a two-band mixer circuit-containing satellite broadcast receiving system as satellite broadcasting becomes more and more popular.

In view of the above conventional problem, an object of the present invention is to provide a multiple-band mixer circuit in which a monitor circuit for checking the operating state of a plurality of mixer circuit blocks is shared by the plurality of mixer circuit blocks.

Other objects and further applications of the present invention will become apparent from the detailed description given hereinafter. However, it should be understood that the detailed description and specific examples, while indicating preferred embodiments of the invention, are given by way of illustration only.

To achieve the above object, there is provided a plural-band mixer circuit comprising a plurality of mixer circuit blocks whose outputs are connected to a selection circuit block, wherein a local oscillator supplies power only to the mixer circuit block appropriate for a band received so that one mixer circuit block is operated at a time. The circuit being characterised in that a parallel circuit made up of a resistor and a capacitor is connected for common use for each band to monitor the diode current in the mixer diode in each mixer circuit block, one terminal of the parallel circuit being connected to a fixed potential and the other terminal, which supplies the monitored voltage representative of said diode current, being connected via a reactance to the output of each mixer block.

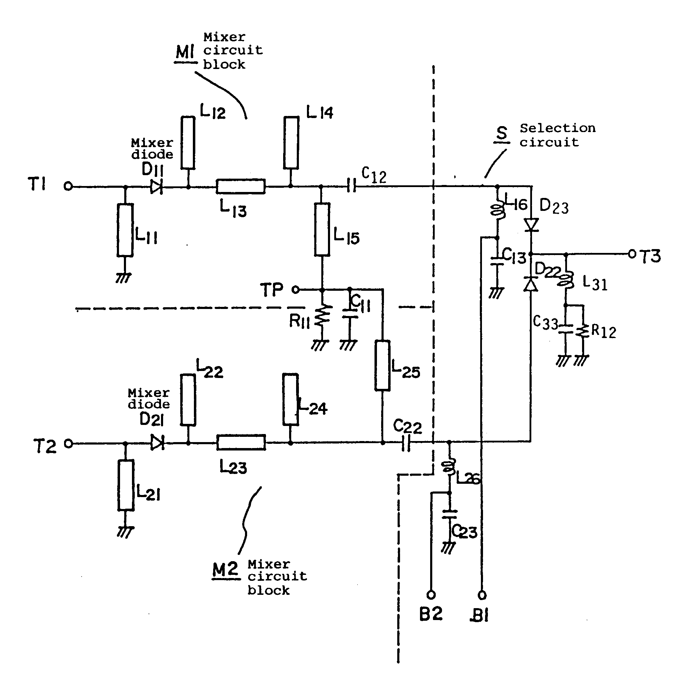

The present invention will become more fully understood from the detailed description given hereinbelow and the accompanying drawings which are given by way of illustration only, and thus are not limitative of the present invention and wherein:
the figure is a circuit diagram of the two-band mixer circuit of an embodiment of the present invention.

The two-band mixer circuit of an embodiment of the invention is described with reference to the attached drawings. It should be noted that the present invention is not limited to a mixer circuit for two bands, the invention being applicable to more than two-band mixer circuits i.e. plural-band circuits.

Referring to the figure, the two-band mixer circuit comprises a mixer circuit block M1 for a first band, a mixer circuit block M2 for a second band and a selection circuit block S for selecting the mixer circuit block M1 or M2. When the circuit has received a signal, the received signal and a local signal are supplied to the appropriate mixer circuit block M1 or M2. Specifically, when the first band has been received, the first band signal and a local signal are input to terminal T1 of the band mixer circuit block M1 and converted to an IF signal by a mixer diode D₁₁. The IF signal from the band mixer circuit block M1 is selected by the selection circuit block S and output to terminal T3. When the second band has been received, the second band signal and a local signal are input to terminal T2 of the band mixer circuit block M2 and converted to an IF signal by a mixer diode D₂₁. The IF signal from the band mixer circuit block M2 is then selected by the selection circuit block S and output to terminal T3.

An appropriate band mixer circuit block M1 or M2 is selected by the line voltage supplied from a local oscillator selectively to the terminal B1 or B2 of the selection circuit block S. The local oscillator supplies power only to the mixer circuit block appropriate for a received band, so that the mixer circuit block appropriate for the received band alone is operated. Voltage is applied selectively to the terminal B1 or B2 of the selection circuit block S, for connection with a necessary mixer circuit block alone, thus preventing the influence by the mixer circuit block which is not operated. In the two-band mixer circuit of the present invention, a circuit comprising a resistor R₁₁ and a capacitor C₁₁ monitors the diode current of the band mixer circuit block M1 or M2. It is possible to check the mixer circuit block M1 or M2 for normal operation by measuring the voltage at the terminal TP of the monitor circuit.

According to the present invention, since the local oscillator supplies power only to the mixer circuit block appropriate for the band received, the two mixer circuit blocks will never operate simultaneously.

According to the present invention, only one parallel circuit comprising the resistor R₁₁ and the capacitor C₁₁ is connected as a monitor circuit to the two band mixer circuit blocks M1 and M2. The diode current for each band is led through a reactance L₁₅ or L₂₅ to the parallel circuit. Therefore, diode current of either mixer circuit block can be measured at one monitor terminal TP.

In the two-band mixer circuit of the present invention, the diode current of the mixer circuit block M1 or M2 flows through the reactance L₁₅ or L₂₅ to the resistor R₁₁. When a local signal is supplied to the terminal T2 of the mixer circuit block M2, for instance, the diode current flows through L₂₁, D₂₁, L₂₃, L₂₅ and R₁₁. At this time, the monitor circuit is linked via the reactance L₁₅ with the other mixer circuit block M1, but the circuit is not influenced by the mixer circuit block M1 as direct current is blocked by a coupling capacitor C₁₂ and the reverse direction characteristic of the mixer diode D₁₁. The similar function works when the mixer circuit block M1 receives a band. Accordingly, it is possible to check that each band mixer circuit block operates normally in receiving the band.

In the figure, L₁₁ through L₁₆, L₂₁ through L₂₆ and L₃₁ are reactance, D₁₁ and D₂₁ are mixer diodes, R₁₁ and R₁₂ are resistors, C₁₁, C₁₃, C₂₃ and C₃₃ are capacitors, and D₁₂ and D₂₂ are diodes.

According to the present invention, as mentioned above, the multiple-band mixer circuit contains a monitor circuit for common use by each band mixer circuit block, making it possible to check each band mixer circuit block for normal operation. Since one monitor circuit is shared by multiple mixer circuit blocks, the circuit can be made small in size.

Thus, this invention provides a small, effective multiple-band mixer circuit which shares a parallel circuit of a resistor and a capacitor for monitoring diode current for each band, the parallel circuit monitoring each band accurately.

There are described above novel features which the skilled man will appreciate give rise to advantages. These are each independent aspects of the invention to be covered by the present application, irrespective of whether or not they are included within the scope of the following claim.

## Claims

1. Plural-band mixer circuit comprising a plurality of mixer circuit blocks (M1, M2) whose outputs are connected to a selection circuit block (S), wherein a local oscillator supplies power only to the mixer circuit block appropriate for a band received so that one mixer circuit block is operated at a time, the circuit being characterised in that a parallel circuit made up of a resistor (R11) and a capacitor (C11) is connected for common use for each band to monitor the diode current in the mixer diode (D11, D21) in each mixer circuit block, one terminal of the parallel circuit being connected to a fixed potential and the other terminal, which supplies the monitored voltage representative of said diode current, being connected via a reactance (L15, L25) to the output of each mixer block.

## Patentansprüche

1. Mehrband-Mischerschaltkreis mit mehreren Mischer-Schaltkreisblöcken (M1, M2), deren Ausgänge mit einem Wählschaltkreisblock (S) verbunden sind, wobei ein Orts-Oszillator nur dem für ein empfangenes Band geeigneten Mischer-Schaltkreisblock Energie zuführt, so daß nur immer ein Mischer-Schaltkreis arbeitet, wobei der Schaltkreis
**dadurch gekennzeichnet** ist,
daß ein Parallel-Schaltkreis, der aus einem Widerstand (11) und einer Kapazität (11) gebildet ist, zum Überwachen des Diodenstromes der Mischerdiode (11, D21) in jedem Mischersschaltkreisblock zur gemeinsamen Verwendung für jedes Band angeschlossen ist, wobei ein Anschluß des parallelen Schaltkreises mit einem festen Potential verbunden ist, und wobei der andere Anschluß, der die überwachte den Diodenstrom wiedergebende Spannung zuführt, über eine Reaktanz (L15, L25) an den Ausgang jedes Mischerblockes angeschlossen ist.

## Revendications

1. Circuit mélangeur pour plusieurs bandes comprenant plusieurs blocs (M1, M2) de circuit mélangeur dont les sorties sont connectées à un bloc (S) de circuit de sélection, dans lequel un oscillateur local alimente uniquement le bloc approprié du circuit mélangeur pour une bande reçue de sorte qu' un bloc du circuit mélangeur est actionné à la fois, le circuit étant caractérisé en ce qu'un circuit parallèle constitué d'une résistance (R11) et d'un condensateur (C11) est connecté pour un usage commun pour chaque bande afin de contrôler le courant de diode dans la diode mélangeuse (D11, D21) dans chaque bloc du circuit mélangeur, une borne du circuit parallèle étant connectée à un potentiel fixe et l'autre borne, qui applique la tension contrôlée représentative dudit courant de diode, étant connectée par l'intermédiaire d'une réactance (L15, L25) à la sortie de chaque bloc mélangeur.
